# EUROPEAN PATENT SPECIFICATION

(11) **EP 4 485 527 B1**
(45) Date of publication and mention of the grant of the patent: **25.02.2026**
(21) Application number: 23181337.9
(22) Date of filing: 26.06.2023
(51) Int. Cl.: H01L 23/433, H01L 23/495

(54) **A METHOD FOR MANUFACTURING A SEMICONDUCTOR PACKAGE ASSEMBLY AS WELL AS A SEMICONDUCTOR PACKAGE ASSEMBLY OBTAINED WITH THIS METHOD**
VERFAHREN ZUR HERSTELLUNG EINER HALBLEITERPAKETANORDNUNG SOWIE MIT DIESEM VERFAHREN ERHALTENE HALBLEITERPAKETANORDNUNG
PROCÉDÉ DE FABRICATION D'UN ENSEMBLE DE BOÎTIER DE SEMI-CONDUCTEUR ET ENSEMBLE DE BOÎTIER DE SEMI-CONDUCTEUR OBTENU PAR CE PROCÉDÉ

(43) Date of publication of application: 01.01.2025
(73) Proprietor: Nexperia B.V., 6534 AB Nijmegen (NL)
(72) Inventor: Ramalingam, Vegneswary, 71450 Seremban (MY); Funke, Hans-Juergen, 22529 Hamburg (DE)
(74) Representative: Pjanovic, Ilija

(56) References cited:
- EP-A1- 3 428 962
- US-A- 5 672 910
- US-A1- 2017 179 009

## Description

### TECHNICAL FIELD

The present disclosure relates to a method for manufacturing a semiconductor package assembly consisting of a semiconductor package and a molding resin case.

### BACKGROUND OF THE DISCLOSURE

One critical property of semiconductor package assemblies for high voltage devices (> 500V), such as those described, for example, in patent documents EP 3 428 962 A1, US 5 672 910 A and US 2017/179009 A1, is the creepage and clearance distance of the metal parts within the semiconductor package assembly. In high voltage applications the minimum creepage distance of electrical conductors is described, e.g. in IEC60664-1 and IPC2221A. The requirement for the minimum distances according to these standards is in contradiction to the trend for higher density electronics which require smaller package assemblies.

In known power semiconductor devices no proper solution is yet presented which incorporate a superior electrical insulation to mitigate the risk of electrical arcing for surface mounted devices. Moreover, power semiconductor devices require a large exposed heatsink element for an effective thermal dissipation of heat being generated. However, at higher operating voltages, the arcing risk is higher and thermal build-up inside the package will increase as well.

Accordingly, it is a goal of the present disclosure to provide an improved semiconductor package assembly capable of suppressing failures in case the distances as defined in the standard are violated e.g. due to limitations in package size.

### SUMMARY OF THE DISCLOSURE

According to a first example of the disclosure, a method for manufacturing a semiconductor package assembly is proposed. The method comprising the steps of i) forming at least one semiconductor package by means of the sub-steps i1) providing a lead frame made from a metal material having a first frame side and a second frame side opposite to the first frame side as well as having at least two terminals; i2) providing at least one semiconductor die structure having a first die side and a second die side opposite to the first die side with its second die side on the first frame side of the lead frame; i3) electrically and mechanically attaching the at least one semiconductor die structure to the terminals of the lead frame; i4) attaching a heat sink element on the first die side and/or the second die side of the semiconductor die structure; and ii) encapsulating the at least one semiconductor die structure, the heat sink element and the plurality of terminals with a molding resin leaving at least a portion of the heat sink and at least a portion of the at least two terminals exposed. With the above steps at least one encapsulated semiconductor package assembly is formed.

The method further comprises the step of iii) providing, at least prior to the encapsulating step ii), a layer comprised of at least a silicate containing mineral on the lead frame and/or the semiconductor die structure adjacent to the heat sink element.

The silicate containing mineral mounted on the lead frame and/or the semiconductor die structure adjacent to the heat sink element, shields the latter from the leads of the lead frame and provides an improved creepage performance, in particular for top cool semiconductor package assemblies having a top surface heat sink. In addition, the presence of such silicate containing mineral allows to increase the design margins of the semiconductor package assembly, as it would be possible to develop package assemblies with larger heatsinks for step-up thermal dissipation.

In a further example of the method according to the disclosure step iii) is performed prior to step i2), and comprises providing an adhesive tape having an adhesive side and containing at least one layer comprised of the at least a silicate containing mineral on the adhesive side, and mounting at least the lead frame on the adhesive side of the adhesive tape.

The application of an adhesive tape as a back side tape in film-assisted molding techniques can support the manufacturability of thinner lead frames.

In a further example, in the method according to the disclosure step iii) is followed by the step of vi) removing the adhesive tape leaving the at least one layer comprised of the at least a silicate containing mineral exposed.

The present disclosure also pertains to a semiconductor package assembly consisting of a semiconductor package and a molding resin case as manufactured in accordance with one or more of the method claims of the present disclosure. In a particular example, the semiconductor package at least comprises a lead frame made from a metal material having a first frame side and a second frame side opposite to the first frame side as well as having at least two terminals; at least one semiconductor die structure having a first die side and a second die side opposite to the first die side with its second die side on the first frame side of the lead frame; a plurality of connections electrically and mechanically connecting the at least one semiconductor die structure with the terminals of the lead frame; at least one heat sink element mounted to the semiconductor die structure; and at least one layer comprised of at least a silicate containing mineral at least adjacent to the at least one heat sink element; and a molding resin encapsulating the at least one semiconductor die structure, the at least one heat sink element, the plurality of terminals and the at least one layer comprised of at least a silicate containing mineral with a molding resin leaving at least a portion of the heat sink and at least a portion of the at least two terminals exposed.

The silicate containing mineral mounted on the lead frame and/or the semiconductor die structure adjacent to the heat sink element, shields the latter from the leads of the lead frame and provides an improved creepage performance, in particular for top cool semiconductor package assemblies having a top surface heat sink. In addition, the presence of such silicate containing mineral allows to increase the design margins of the semiconductor package assembly, as it would be possible to develop package assemblies with larger heatsinks for step-up thermal dissipation.

Preferably, the silicate containing mineral is mica. Mica can be reinforced into a high stability composite, which provides a superior electrical insulation and is thus very useful in mitigating the risk of electrical arcing and creepage.

In particular, creepage is further mitigated as in an example, the at least one layer comprised of the at least a silicate containing mineral layer surrounds the heat sink element.

Alternatively, the at least one layer comprised of the at least a silicate containing mineral layer is positioned adjacent to the terminals of the lead frame.

### BRIEF DESCRIPTION OF THE DRAWINGS

The disclosure will now be discussed with reference to the drawings, which show in:
Figures 1A-1F depict various examples of a singulated semiconductor package assembly according to the disclosure;
Figures 2A-2D depict various manufacturing steps of a method according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

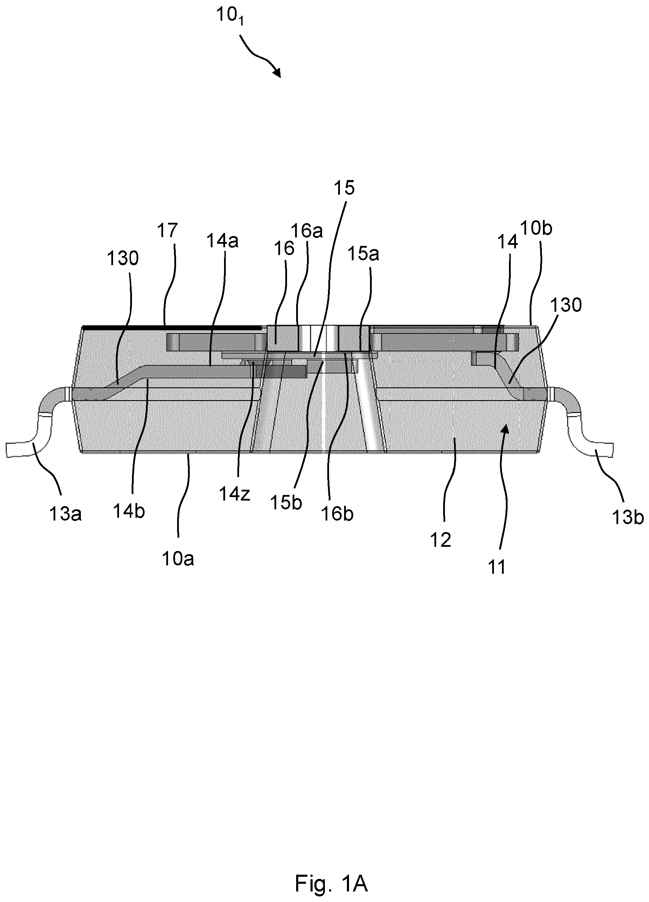

Figures 1A-1F depict various examples of a semiconductor package assembly according to the disclosure, which are indicated with reference numerals 10₁-10₆, respectively.

As outlined in the introduction, one critical property of semiconductor package assemblies for high voltage devices (> 500V) is the creepage and clearance distance of the metal parts within the semiconductor package assembly. In high voltage applications the minimum creepage distance of electrical conductors is described, e.g. in IEC60664-1 and IPC2221A. The requirement for the minimum distances according to these standards is in contradiction to the trend for higher density electronics which require smaller package assemblies.

In known power semiconductor devices no proper solution is yet presented which incorporate a superior electrical insulation to mitigate the risk of electrical arcing for surface mounted devices. Moreover, power semiconductor devices require a large exposed heatsink element for an effective thermal dissipation of heat being generated. However, at higher operating voltages, the arcing risk is higher and thermal build-up inside the package will increase as well.

Solutions for the above adverse effects of high voltages applied in a semiconductor package assembly according to the state of the art are depicted in the examples 10₁-10₆ of Figures 1A-1F, respectively. The semiconductor package assemblies 10₁-10₆ all consists of a semiconductor package 11 and a molding resin case 12, as shown in the cutaway Figure 1A.

In all examples, the semiconductor package 11 is composed of a lead frame 14 having a first lead frame side 14a and a second lead frame side 14b opposite to the first lead frame side 14a. The lead frame 14 also comprises at least two terminals, denoted as leads 13. A semiconductor die structure 15 has a first die side 15a and a second die side 15b opposite to the first die side 15a and is mounted with its second die side 15b on the first lead frame side 14a of the lead frame 14, for example at a die paddle 14z. In addition, one or more bond elements 130 may be provided which are electrically connected with relevant parts of the semiconductor die structure 15 with the leads 13. The bond elements may be bond clips of bond wires and extend into the leads 13.

In addition, a heat sink element 16 is provided having a planar configuration with a first heat sink side 16a and a second heat sink side 16b opposite to the first heat sink side 16a. The heat sink element 16 is mechanically connected with the semiconductor die structure 15 (thereby contacting the first die side 15a or second die side 15b with its second heat sink side 16b).

As shown in Figure 1A, the molding resin case 12 encapsulates at least the semiconductor die structure 15, the lead frame 14, the heat sink element 16 and the bond elements 130 and leaves a part of the bond element 130 partly exposed, thereby forming leads 13. Moreover, the first heat sink side 16a of the encapsulated heat sink element 16 is also not encapsulated by the molding resin case 12, but is exposed similar as the leads 13. The exposed first heat sink side 16a of the heat sink element 16 allows for a proper heat dissipation. The encapsulated semiconductor die structure 15, the lead frame 14, the heat sink element 16, and the bond element 130 (both its encapsulated part and exposed part, being the leads 13) are considered a semiconductor package assembly 10 (10₁-10₆).

Such semiconductor package assembly 10 (10₁-10₆) can be used in all kinds of electronics applications. To this end the semiconductor package assembly 10 (10₁-10₆) can be mounted to a Printed Circuit Board, PCB, note shown, by soldering the leads 13 (13-13b) at the relevant mounting locations on the PCB.

In power semiconductor devices which are operated at higher operating voltages, the arcing risk is higher and the thermal build-up inside the package will increase as well. In order to suppress failures in case the distances as defined in the standard are violated e.g. due to limitations in package size and to mitigate the risk of electrical arcing for surface mounted devices, at least one layer 17, 17a-1, 17a-2, 17a-3 is provided which layer 17, 17a-1, 17a-2, 17a-3 is comprised of at least a silicate containing mineral.

As depicted in the Figures 1A-1F, the at least one layer 17, 17a-1, 17a-2, 17a-3 comprised of at least a silicate containing mineral is provided at least adjacent to the heat sink element 16 and optionally also adjacent to the exposed leads 13a.

In this application it is observed that the exposed leads 13b may be connected to the drain and are also electrically connected to the heat sink 16, as clearly depicted in Figure 1A. Accordingly, the leads 13b and the heat sink 16 are on the same potential level. The leads 13a are not electrically connected to the heat sink 16 and may be connected to the source and gate of the semiconductor die structure 15. The potential difference between the leads 13a and the heat sink 16 may induce a higher arcing risk and thermal build-up inside the package.

The molding resin 12 also encapsulates the at least one layer 17, 17a, 17b, yet in an exposed manner similar to the heat sink element 16.

The silicate containing mineral 17, 17a-1, 17a-2, 17a-3 mounted on the lead frame 14 and/or the semiconductor die structure 15 adjacent to the heat sink element 16 shields the latter from the leads 13a of the lead frame 14 and provides an improved creepage performance, in particular for top cool semiconductor package assemblies having a top surface heat sink element 16, as shown in the examples 10₁-10₆ of the Figures 1A-1F.

In addition, the presence of such silicate containing mineral 17, 17a-1, 17a-2, 17a-3 allows to increase the design margins of the semiconductor package assembly, as it would be possible to develop package assemblies with larger heatsinks for step-up thermal dissipation.

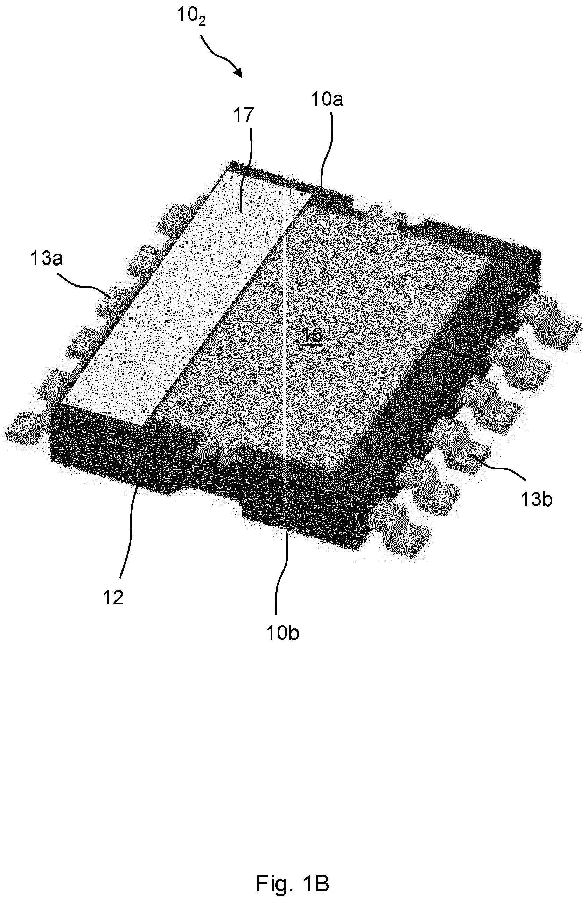

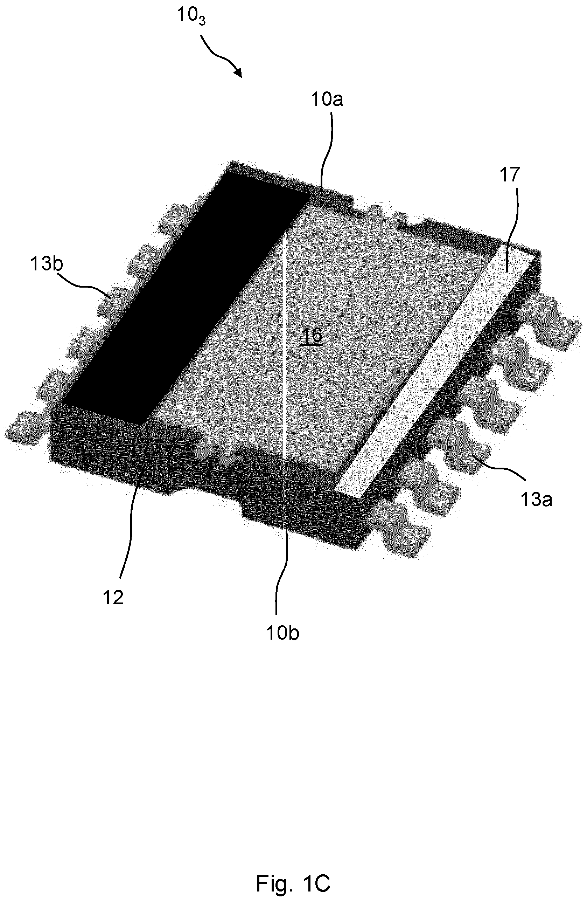

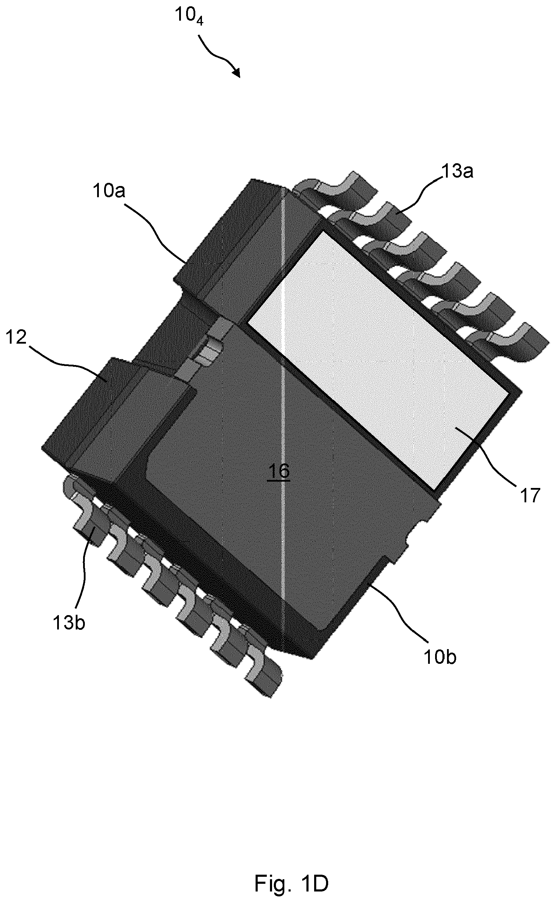

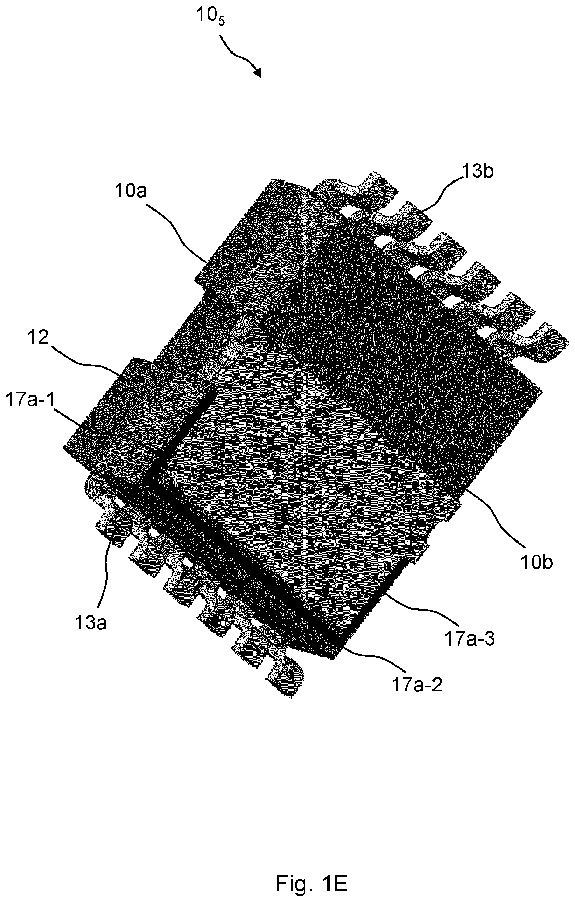

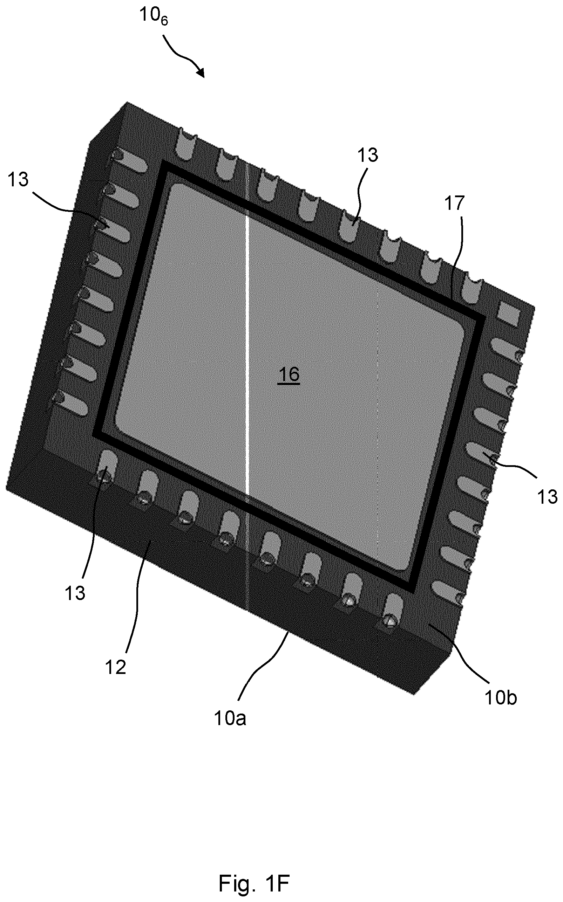

In Figures 1A, 1B and 1C the heat sink element 16 and the silicate containing mineral 17 are positioned at a first, top surface side 10a of the semiconductor package assemblies 10₁, 10₂ and 10₃, shielding the heat sink 16 from the leads 13a (which are on a different potential level than the heat sink 16). In examples of Figures 1D and 1E the heat sink element 16 and the silicate containing mineral 17 are positioned at a second, bottom surface side 10b of the semiconductor package assemblies 10₄ and 10₅. In all examples the semiconductor package assemblies 10₁-10₆ are to be mounted with their second, bottom surface side 10b on a PCB (no shown), and the silicate containing mineral 17 is electrically shielding the heat sink 16 from the leads 13a (which are on a different potential level than the heat sink 16), thereby limiting the risk of arcing. In figure 1E strips 17a-1, 17a-2, 17a-3 of silicate containing mineral are partially positioned around the heat sink 16 shielding the leads 13a (which are on a different potential level). In addition, the example of Figure 1F, shows a leadless semiconductor package assembly 10₆.

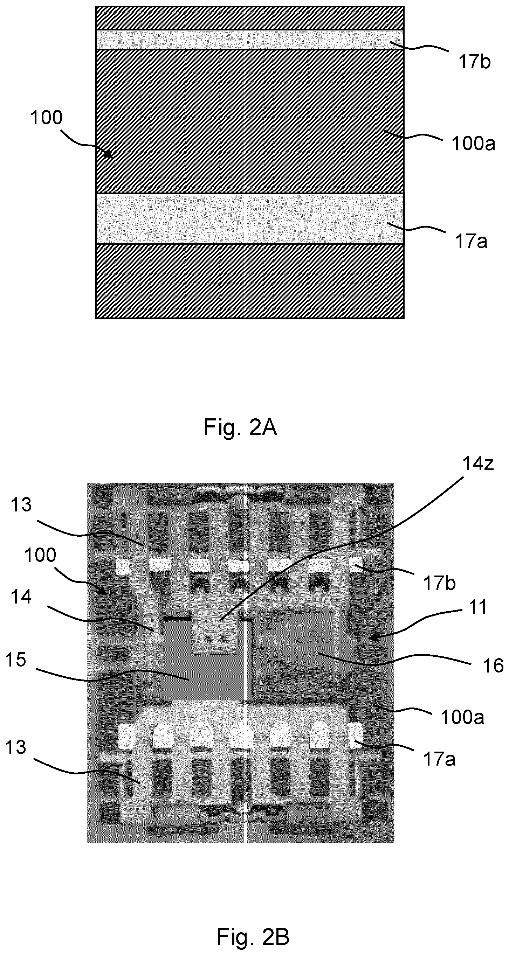

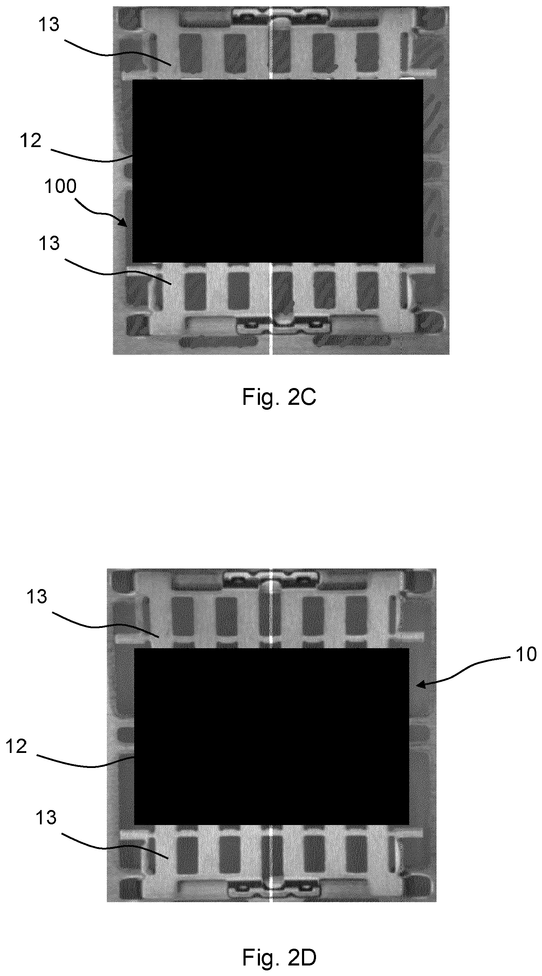

Figures 2A-2D depict various manufacturing steps of a method according to the disclosure. The method intends to form at least one semiconductor package 10₁-10₆ by means of the sub-steps of step i1) of providing a lead frame 14 made from a metal material having a first frame side 14a and a second frame side 14b opposite to the first frame side 14a as well as having at least two terminals 13; step i2) of providing at least one semiconductor die structure 15 having a first die side 15a and a second die side 15b opposite to the first die side 15a with its second die side 15b on the first frame side 14a of the lead frame 14, for example at the location of a die paddle 14z (see Figure 2B).

The next step i3) pertains to electrically and mechanically attaching the at least one semiconductor die structure 15 to the terminals 13 of the lead frame 14, for example with the use of bond clips or bond wires 130. Moreover, see Figure 2B, in a next step i4) a heat sink element 16 is attached on the first die side 15a and/or the second die side 15b of the semiconductor die structure 15 or optionally to the lead frame 14.

Prior to the encapsulating step ii) for encapsulating the at least one semiconductor die structure 15, the heat sink element 16, the lead frame 14 and the plurality of terminals 13 with a molding resin 12, the method performs the step iii) of providing a layer 17, 17a, 17b comprised of at least a silicate containing mineral on the lead frame 14 and/or the semiconductor die structure 15 adjacent to the heat sink element 16.

Various techniques can be applied for providing the layer 17, 17a, 17b comprised of at least a silicate containing mineral on the lead frame 14 and/or the semiconductor die structure 15 adjacent to the heat sink element 16.

One technique involves a printing technique of the silicate containing mineral into one or more overlapping layers 17, 17a, 17b.

Another technique is disclosed in Figure 2A. In the method step of Figure 2A, an adhesive tape 100 with an adhesive side 100a is provided. On the adhesive side 199a at least one layer 17, 17a, 17b comprised of the at least a silicate containing mineral is provided, for example with a length dimension more or less equal to a width dimension of the lead frame 14. The lead frame 14 is adhered with one of its a lead frame sides (here the second lead frame side 14b) on the adhesive side 100a of the adhesive tape 100, such the at least one layer 17, 17a, 17b of the at least a silicate containing mineral is sandwiched between the tape 100 and the lead frame 14.

After the step of adhering the lead frame 14 to the adhesive tape 100, the previous outlined steps are performed: mounting the least one semiconductor die structure 15 with its second die side 15b on the first frame side 14a of the lead frame 14, for example at the location of a die paddle 14z (see Figure 2B), electrically and mechanically attaching the at least one semiconductor die structure 15 to the terminals 13 of the lead frame 14 and attaching the at least one heat sink element 16 on the first die side 15a and/or the second die side 15b of the semiconductor die structure 15 or optionally to the lead frame 14.

Subsequently, the encapsulating step is performed with the encapsulant 12 leaving the first heat sink side 16a of the heat sink element 16, optionally the layer 17, 17a, 17b of the at least a silicate containing mineral and the leads or terminals 13 exposed, thereby forming at least one encapsulated semiconductor package assembly 10₁-10₆.

The efficiency of the manufacturing method according to the disclosure allows for manufacturing a large number of encapsulated semiconductor package assemblies 10₁-10₆, using an adhesive tape having an adhesive side and containing multiple layers, each comprised of the at least a silicate containing mineral on the adhesive side at certain locations conformal to the number semiconductor packages 11 to be formed on a matrix shaped lead frame 14 containing multiple die paddles 14z and leads 13.

After encapsulation, the individual semiconductor package assemblies 10₁-10₆ can be created using known singulation and lead forming techniques.

### LIST OF REFERENCE NUMERALS USED

- 10₁-10₆: semiconductor package assembly (examples of the disclosure)
- 11: semiconductor package
- 12: molding resin case
- 13a-13b: leads / terminals
- 130: bond element
- 14: lead frame
- 14a: first side of lead frame
- 14b: second side of lead frame
- 14z: lead frame die paddle
- 15: semiconductor die structure
- 15a: first die side of semiconductor die structure
- 15b: second die side of semiconductor die structure
- 16: heat sink
- 16a: first side of heat sink
- 16b: second side of heat sink
- 17; 17a-n; 17b: layer comprised of at least a silicate containing mineral
- 100: tape
- 100a: adhesive side of tape

## Claims

1. A method for manufacturing a semiconductor package assembly, the method comprising the steps of
i) forming at least one semiconductor package by means of the sub-steps:
i1) providing a lead frame made from a metal material having a first frame side and a second frame side opposite to the first frame side as well as having at least two terminals;
i2) providing at least one semiconductor die structure having a first die side and a second die side opposite to the first die side with its second die side on the first frame side of the lead frame;
i3) electrically and mechanically attaching the at least one semiconductor die structure to the terminals of the lead frame;
i4) attaching a heat sink element on the first die side and/or the second die side of the semiconductor die structure;
and
ii) encapsulating the at least one semiconductor die structure, the heat sink element and the plurality of terminals with a molding resin leaving at least a portion of the heat sink and at least a portion of the at least two terminals exposed, thereby forming at least one encapsulated semiconductor package assembly;
wherein the method further comprises the step of:
iii) at least prior to the encapsulating step ii), providing a layer comprised of at least a silicate containing mineral on the lead frame and/or the semiconductor die structure adjacent to the heat sink element.

2. The method according to claim 1, wherein step iii) is performed prior to step i2), and comprises
providing an adhesive tape having an adhesive side and containing at least one layer comprised of the at least a silicate containing mineral on the adhesive side, and
mounting at least the lead frame on the adhesive side of the adhesive tape.

3. The method according to claim 2, wherein step iii) is followed by the step of
vi) removing the adhesive tape leaving the at least one layer comprised of the at least a silicate containing mineral exposed.

4. The method according to any one or more of the preceding claims, wherein the silicate containing mineral is mica.

5. The method according to any one or more of the preceding claims, wherein the at least one layer comprised of the at least a silicate containing mineral layer surrounds the heat sink element.

6. The method according to any one or more of the preceding claims, wherein the at least one layer comprised of the at least a silicate containing mineral layer is adjacent to the terminals of the lead frame.

7. A semiconductor package assembly consisting of a semiconductor package and a molding resin case as manufactured in accordance with one or more of the method claims 1-6, the semiconductor package at least comprising:
a lead frame made from a metal material having a first frame side and a second frame side opposite to the first frame side as well as having at least two terminals;
at least one semiconductor die structure having a first die side and a second die side opposite to the first die side with its second die side on the first frame side of the lead frame;
a plurality of connections electrically and mechanically connecting the at least one semiconductor die structure with the terminals of the lead frame;
at least one heat sink element mounted to the semiconductor die structure;
at least one layer comprised of at least a silicate containing mineral at least adjacent to the at least one heat sink element; and
a molding resin encapsulating the at least one semiconductor die structure, the at least one heat sink element, the plurality of terminals and the at least one layer comprised of at least a silicate containing mineral with a molding resin leaving at least a portion of the heat sink and at least a portion of the at least two terminals exposed.

8. The semiconductor package assembly according to claim 7, wherein the silicate containing mineral is mica.

9. The semiconductor package assembly according to claim 7 or 8, wherein the at least one layer comprised of the at least a silicate containing mineral layer is positioned around the heat sink element.

10. The semiconductor package assembly according to claim 7, 8 or 9, wherein the at least one layer comprised of the at least a silicate containing mineral layer is positioned adjacent to the terminals of the lead frame.

## Patentansprüche

1. Verfahren zum Herstellen einer Halbleiterpaketanordnung, wobei das Verfahren die folgenden Schritte umfasst:
i) Bilden mindestens eines Halbleiterpakets mit Hilfe der Unterschritte:
i1) Bereitstellen eines Leiterrahmens aus einem Metallmaterial, der eine erste Rahmenseite und eine zweite Rahmenseite aufweist, die der ersten Rahmenseite gegenüberliegt, sowie mindestens zwei Anschlüsse aufweist;
i2) Bereitstellen mindestens einer Halbleiterchipstruktur, die eine erste Chipseite und eine der ersten Chipseite gegenüberliegende zweite Chipseite aufweist, wobei ihre zweite Chipseite auf der ersten Rahmenseite des Leiterrahmens liegt;
i3) elektrisches und mechanisches Befestigen der mindestens einen Halbleiterchipstruktur an den Anschlüssen des Leiterrahmens;
i4) Befestigen eines Wärmesenkenelements auf der ersten Chipseite und/oder der zweiten Chipseite der Halbleiterchipstruktur;
und
ii) Verkapseln der mindestens einen Halbleiterchipstruktur, des Wärmesenkenelements und der Vielzahl von Anschlüssen mit einem Gießharz, wobei mindestens ein Teil der Wärmesenke und mindestens ein Teil der mindestens zwei Anschlüsse freigelegt werden, wodurch mindestens eine eingekapselte Halbleiterpaketanordnung gebildet wird;
wobei das Verfahren ferner den folgenden Schritt umfasst:
iii) mindestens vor dem Verkapselungsschritt ii), Bereitstellen einer Schicht, die aus mindestens einem silikathaltigen Mineral besteht, auf dem Leiterrahmen und/oder der Halbleiterchipstruktur neben dem Wärmesenkenelement.

2. Verfahren nach Anspruch 1, wobei Schritt iii) vor Schritt i2) durchgeführt wird, und Folgendes umfasst:
Bereitstellen eines Klebebandes, das eine Klebeseite aufweist und mindestens eine Schicht enthält, die aus dem mindestens einen silikathaltigen Mineral auf der Klebeseite besteht, und
Anbringen mindestens des Leiterrahmens auf der Klebeseite des Klebebandes.

3. Verfahren nach Anspruch 2, wobei Schritt iii) gefolgt wird von dem folgenden Schritt:
vi) Entfernen des Klebebandes, wobei die mindestens eine Schicht, die aus dem mindestens einen silikathaltigen Mineral besteht, freigelegt wird.

4. Verfahren nach einem oder mehreren der vorstehenden Ansprüche, wobei das silikathaltige Mineral Glimmer ist.

5. Verfahren nach einem oder mehreren der vorstehenden Ansprüche, wobei die mindestens eine Schicht, die aus der mindestens einen silikathaltigen Mineralschicht besteht, das Wärmesenkenelement umgibt.

6. Verfahren nach einem oder mehreren der vorstehenden Ansprüche, wobei die mindestens eine Schicht, die aus der mindestens einen silikathaltigen Mineralschicht besteht, an die Anschlüsse des Leiterrahmens angrenzt.

7. Halbleiterpaketanordnung, bestehend aus einem Halbleiterpaket und einem Gießharzgehäuse, hergestellt nach einem oder mehreren der Verfahrensansprüche 1 bis 6, wobei das Halbleiterpaket mindestens Folgendes umfasst:
einen Leiterrahmen aus einem Metallmaterial, der eine erste Rahmenseite und eine zweite Rahmenseite aufweist, die der ersten Rahmenseite gegenüberliegt, sowie mindestens zwei Anschlüsse aufweist;
mindestens eine Halbleiterchipstruktur, die eine erste Chipseite und eine der ersten Chipseite gegenüberliegende zweite Chipseite aufweist, wobei ihre zweite Chipseite auf der ersten Rahmenseite des Leiterrahmens liegt;
eine Vielzahl von Verbindungen, welche die mindestens eine Halbleiterchipstruktur mit den Anschlüssen des Leiterrahmens elektrisch und mechanisch verbinden;
mindestens ein Wärmesenkenelement, das an der Halbleiterchipstruktur angebracht ist;
mindestens eine Schicht, die aus mindestens einem silikathaltigen Mineral besteht, die mindestens an das mindestens eine Wärmesenkenelement angrenzt; und
ein Gießharz, das die mindestens eine Halbleiterchipstruktur, das mindestens eine Wärmesenkenelement, die Vielzahl von Anschlüssen und die mindestens eine Schicht, die aus mindestens einem silikathaltigen Mineral besteht, mit einem Gießharz verkapselt, wobei mindestens ein Teil der Wärmesenke und mindestens ein Teil der mindestens zwei Anschlüsse freigelegt werden.

8. Halbleiterpaketanordnung nach Anspruch 7, wobei das silikathaltige Mineral Glimmer ist.

9. Halbleiterpaketanordnung nach Anspruch 7 oder 8, wobei die mindestens eine Schicht, die aus mindestens einer silikathaltigen Mineralschicht besteht, um das Wärmesenkenelement positioniert ist.

10. Halbleiterpaketanordnung nach Anspruch 7, 8 oder 9, wobei die mindestens eine Schicht, die aus dem mindestens einen silikathaltige Mineral besteht, angrenzend an die Anschlüsse des Leiterrahmens positioniert ist.

## Revendications

1. Procédé de fabrication d'ensemble d'encapsulation de semi-conducteur, le procédé comprenant les étapes consistant à
i) former au moins une encapsulation de semi-conducteur au moyen des sous-étapes suivantes :
i1) fournir une grille de connexion constituée d'un matériau métallique ayant un premier côté de grille et un second côté de grille opposé au premier côté de grille et comportant au moins deux bornes ;
i2) fournir au moins une structure de puce semi-conductrice ayant un premier côté de puce et un second côté de puce opposé au premier côté de puce, son second côté de puce se trouvant sur le premier côté de grille de la grille de connexion ;
i3) relier électriquement et mécaniquement l'au moins une structure de puce semi-conductrice aux bornes de la grille de connexion ;
i4) relier un élément puits thermique sur le premier côté de puce et/ou le second côté de puce de la structure de puce semi-conductrice ;
et
ii) encapsuler l'au moins une structure de puce semi-conductrice, l'élément puits thermique et la pluralité de bornes avec une résine de moulage laissant au moins une partie du puits thermique et au moins une partie des au moins deux bornes exposées, formant ainsi au moins un ensemble d'encapsulation de semi-conducteur encapsulé ;
le procédé comprenant en outre les étapes consistant à :
iii) au moins avant l'étape d'encapsulation ii), fournir une couche constituée d'au moins un minéral contenant un silicate sur la grille de connexion et/ou la structure de puce semi-conductrice adjacente à l'élément puits thermique.

2. Procédé selon la revendication 1, dans lequel l'étape iii) est réalisée avant l'étape i2), et comprend les étapes consistant à
fournir un ruban adhésif ayant un côté adhésif et contenant au moins une couche constitue du au moins un minéral contenant un silicate sur le côté adhésif, et
monter au moins la grille de connexion sur le côté adhésif du ruban adhésif.

3. Procédé selon la revendication 2, dans lequel l'étape iii) est suivie de l'étape consistant à
vi) retirer le ruban adhésif en laissant la au moins une couche constituée du au moins un minéral contenant un silicate exposée.

4. Procédé selon l'une quelconque ou plusieurs des revendications précédentes, dans lequel le minéral contenant un silicate est le mica.

5. Procédé selon l'une quelconque ou plusieurs des revendications précédentes, dans lequel la au moins une couche constituée de la au moins une couche de minéral contenant un silicate entoure l'élément puits thermique.

6. Procédé selon l'une quelconque ou plusieurs des revendications précédentes, dans lequel la au moins une couche constituée de la au moins une couche de minéral contenant un silicate est adjacente aux bornes de la grille de connexion.

7. Ensemble d'encapsulation de semi-conducteur constitué d'une encapsulation de semi-conducteur et d'un boîtier de résine de moulage tel que fabriqué selon une ou plusieurs des revendications de procédé 1 à 6, l'encapsulation de semi-conducteur comprenant au moins :
une grille de connexion constituée d'un matériau métallique ayant un premier côté de grille et un second côté de grille opposé au premier côté de grille et comportant au moins deux bornes ;
au moins une structure de puce semi-conductrice ayant un premier côté de puce et un second côté de puce opposé au premier côté de puce, son second côté de puce se trouvant sur le premier côté de grille de la grille de connexion ;
une pluralité de liaisons reliant d'une manière électrique et mécanique la au moins une structure de puce semi-conductrice aux bornes de la grille de connexion ;
au moins un élément puits thermique monté sur la structure de puce semi-conductrice ;
au moins une couche constituée d'au moins un minéral contenant un silicate au moins adjacente au au moins un élément puits thermique ; et
une résine de moulage encapsulant la au moins une structure de puce semi-conductrice, le au moins un élément puits thermique, la pluralité de bornes et la au moins une couche constituée d'au moins un minéral contenant un silicate avec une résine de moulage laissant au moins une partie du puits thermique et au moins une partie des au moins deux bornes exposées.

8. Ensemble d'encapsulation de semi-conducteur selon la revendication 7, dans lequel le minéral contenant un silicate est le mica.

9. Ensemble d'encapsulation de semi-conducteur selon la revendication 7 ou 8, dans lequel la au moins une couche constitué de la au moins une couche de minéral contenant un silicate est positionnée autour de l'élément puits thermique.

10. Ensemble d'encapsulation de semi-conducteur selon la revendication 7, 8 ou 9, dans lequel la au moins une couche constituée de la au moins une couche de minéral contenant un silicate est positionnée adjacente aux bornes de la grille de connexion.
